# EUROPÄISCHE PATENTSCHRIFT

(11) **EP 3 235 141 B1**
(45) Veröffentlichungstag und Bekanntmachung des Hinweises auf die Patenterteilung: **13.11.2019**
(21) Anmeldenummer: 15807617.4
(22) Anmeldetag: 02.12.2015
(51) Int. Cl.: H04B 5/00, E05D 11/00

(54) **VERFAHREN UND VORRICHTUNG ZUR ÜBERTRAGUNG VON ELEKTRISCHER LEISTUNG UND/ODER VON SIGNALEN ZWISCHEN EINER WAND UND EINEM GEGENÜBER DIESER WAND SCHWENKBAREN FLÜGEL**
METHOD AND DEVICE FOR TRANSMITTING ELECTRICAL POWER AND/OR SIGNALS BETWEEN A WALL AND A LEAF PIVOTABLE RELATIVE THERETO
PROCÉDÉ ET DISPOSITIF DE TRANSMISSION DE PUISSANCE ÉLECTRIQUE ET/OU DE SIGNAUX ENTRE UNE PAROI ET UNE AILE POUVANT PIVOTÉE PAR RAPPORT À CETTE PAROI

(30) Priorität: 15.12.2014 DE 102014118597
(43) Veröffentlichungstag der Anmeldung: 25.10.2017
(73) Patentinhaber: Dr. Hahn GmbH & Co. KG, D-41189 Mönchengladbach (DE)
(72) Erfinder: GROßE, Burkhard, 35415 Pohlheim (DE)
(74) Vertreter: Kluin, Jörg-Eden
(86) Internationale Anmeldenummer: PCT/EP2015/078326
(87) Internationale Veröffentlichungsnummer: WO 2016/096429

(56) Entgegenhaltungen:
- DE-A1- 3 915 812
- JP-A- 2013 257 890
- US-B1- 8 847 580

## Beschreibung

Die Erfindung betrifft ein Verfahren und eine Vorrichtung zur Übertragung von elektrischer Leistung und/oder von Signalen zwischen einer Wand und einem gegenüber dieser Wand schwenkbaren Flügel, mit einer Übertragungseinrichtung.

Ein derartiges Verfahren und eine derartige Vorrichtung sind aus der DE 39 15 812 A1 bekannt. Zur Leistungsübertragung sind konzentrisch angeordnete Spulen oder ein zylindrisch ausgebildeter Kondensator vorgesehen. Eine Signalübertragung soll ebenfalls über die Spulen oder den Kondensator oder über Funk erfolgen.

Nachteilig ist an dieser Vorrichtung, dass zumindest dann, wenn die Leistungs- und/oder Signalübertragung auch induktiv erfolgt, die Übertragung durch äußere Magnetfelder beeinflusst bzw. gestört werden kann. Insbesondere ist es möglich, durch ein gezieltes Anlegen äußerer Magnetfelder eine Übertragung von elektrischer Leistung von einer Wand in den Flügel und eine Signalübertragung zwischen der Wand und dem Flügel bzw. umgekehrt, die beispielsweise zur Ansteuerung und zur Funktionsüberwachung von im Flügel befindlichen Einrichtungen dient, derart zu beeinflussen, dass die Funktionalität dieser Einrichtung nicht mehr gewährleistet ist.

Die WO 2012/123040 A1 schlägt daher zur Verbesserung der Betriebssicherheit Mittel zur Abschirmung der Übertragungseinrichtung gegen äußere magnetische Felder vor. Diese können insbesondere Gehäuse aus weichmagnetischen Werkstoffen umfassen, die Übertragungseinrichtungen umgeben.

Nachteilig ist jedoch der mit diesen Abschirmmitteln verbundene Raumbedarf, so dass insbesondere relativ klein bauende Vorrichtungen nicht mit derartigen Mitteln versehen werden können. Darüber hinaus erhöht sich durch zusätzliche Gehäuse der mit der Herstellung einer derartigen Vorrichtung verbundene, konstruktive Aufwand beträchtlich.

Aus der US 8,847,580 B1 ist eine manipulationsgesicherte, magnetische Abstandsensorvorrichtung bekannt. Sie umfasst einen beweglichen, beispielsweise an einem zu sichernden Türflügel anzuordnenden beweglichen Teil und eine gegenüber diesem feststehend angeordneten Teil. Der bewegliche Teil umfasst einen Permanentmagneten und der feststehende Teil einen magnetischen Sensor zur Erfassung des im feststehenden Teil aufgrund des Permanentmagneten herrschenden magnetischen Flusses. Der feststehende und der bewegliche Teil weisen jeweils eine Gehäusehälfte aus einem Material mit hoher Permeabilität auf. Die Gehäusehälften umschließen bei aneinander angenäherten beweglichen und feststehenden Teilen den Permanentmagneten und den magnetischen Sensor bis auf einen geringen Spalt derart, dass zumindest nahezu kein magnetischer Fluss nach außen dringt und der magnetische Sensor vor dem Einfluss äußerer Magnetfelder geschützt ist. Eine relative Verlagerung des beweglichen Teils gegenüber dem feststehenden Teil kann durch eine Änderung des magnetischen Flusses durch den magnetischen Sensor erfasst werden. Zur Erhöhung der Manipulationssicherheit schlägt die US 8,847,580 B1 in einer Variante vor, magnetische Sensoren außerhalb der Gehäuseteile vorzusehen. Wird mit diesen ein äußeres Feld gemessen, wie es beispielsweise bei einer Vergrößerung des Spaltes aus dem Gehäuse ausdringen kann, so wird dies als Sicherheitsverlust gewertet.

Eine Vorrichtung zur Erfassung der Schließ- und Öffnungsstellungen eines Fensterflügels ist aus der JP 2013-257890 A bekannt. Sie umfasst einen Permanentmagneten und einen Hallsensor, wobei der Hallsensor in der Lage ist, das Magnetfeld des Permanentmagneten und gegebenenfalls eines anderen starken Magneten zu erfassen.

Der Erfindung liegt daher die Aufgabe zugrunde, ein Verfahren und eine Vorrichtung der eingangs genannten Art zu schaffen, die mit geringerem konstruktiven Aufwand wirksam gegen die Beeinflussung durch äußere Magnetfelder geschützt ist.

Diese Aufgabe wird durch das in Anspruch 1 wiedergegebene Verfahren und durch die in Anspruch 4 wiedergegebene Vorrichtung gelöst.

Erfindungsgemäß wird die Magnetfeldstärke in einer Umgebung der Übertragungseinrichtung erfasst und bei Übersteigen eines Magnetfeldstärken-Schwellenwerts ein Störungssignal erzeugt. Die Erfindung stellt daher eine Abkehr von der Lehre der WO 2012/123040 A1 dar, indem nicht versucht wird, schädliche äußere Magnetfelder, die beispielsweise bewusst zum Zwecke einer Sabotage erzeugt werden können, abzuschirmen, sondern diese zu erfassen mit dem Ziel, bei Übersteigen eines Schwellenwertes, oberhalb dessen die Funktionsfähigkeit der Übertragungseinrichtung gefährdet wäre, ein Signal zu erzeugen mit welchem dann beispielsweise eine Einbruchmeldezentrale beaufschlagt wird und dass zum Schutz des Systems gezielt einzelne Systemteile der Leistungsübertragung anpasst oder abschaltet. Die Beaufschlagung letzterer kann in analoger Weise wie eine Beaufschlagung mit einem Signal eines anderen Sensors, beispielsweise eines Glasbruchsensors erfolgen.

Das erfindungsgemäße Verfahren wird mit einer elektrischen Schaltungsanordnung zur Erfassung der Magnetfeldstärke durchgeführt, die mit einer vorbestimmten Versorgungsspannung betrieben wird und die derart ausgebildet ist, dass bei Erfassung eines Magnetfeldes einer oberhalb eines Schwellenwerts liegenden Stärke sich der Leistungsbedarf der Schaltungsanordnung erhöht und diese Erhöhung des Leistungsbedarfs zur Erzeugung des Störungssignals verwendet wird. Die Übermittlung der Information "Fremdmagnetfeld erkannt" erfolgt mit anderen Worten vorzugsweise durch eine Strommodulation.

Das Störungssignal wird - wie bereits erwähnt - vorzugsweise einer EinbruchMeldezentrale zugeleitet. Das Störungssignal kann dann von der EinbruchMeldezentrale als Einbruch- bzw. Sabotageversuch bewertet und verarbeitet werden, so dass die im jeweiligen Fall für einen Einbruch- oder Sabotageversuch vorgesehenen Sicherheitsmaßnahmen durchgeführt werden können.

Die Anwendung des erfindungsgemäßen Verfahrens ist zumindest dann zur Erhöhung der Betriebssicherheit bei der Übertragung von elektrischer Leistung und/oder von Signalen zwischen einer Wand und einem Flügel von Vorteil, wenn diese Übertragung zumindest auch induktiv erfolgt, da insbesondere induktive Übertragungskomponenten durch äußere Magnetfelder beeinflusst und/oder gestört werden können.

Die Vorrichtung zur Durchführung des erfindungsgemäßen Verfahrens umfasst eine Einrichtung zur Erfassung der Magnetfeldstärke in einer Umgebung der Übertragungseinrichtung.

Die Übertragungseinrichtung zur Übertragung von elektrischer Leistung und/oder von Signalen zwischen der Wand und dem Flügel umfasst eine wandseitige und eine flügelseitige Spulenanordnung. Diese Spulenanordnungen weisen vorzugsweise in Spulengehäuse eingebettete Spulenwicklungen auf. Die beiden Gehäuse bestehen vorzugsweise aus einem weichmagnetischen Werkstoff und sind derart ausgebildet und angeordnet, dass eine möglichst streufeldarme magnetische Ankopplung zwischen den beiden Spulen hervorgerufen wird.

Die Einrichtung zur Erfassung der Magnetfeldstärke umfasst einen Magnetfeldsensor, der - besonders bevorzugt - einen Reedschalter und/oder einen Hallsensor aufweisen kann. Diese Bauteile sind dann vorzugsweise derart angeordnet, dass sie von den Magnetfeldern, über die sich die wandseitige und die flügelseitige Spulenanordnung in induktiver Wirkverbindung befindet, nicht durchflossen werden.

Hierzu ist der Magnetfeldsensor erfindungsgemäß auf einer Platine der elektrischen Schaltungsanordnung vorgesehen, wobei die Platine an einer Außenseite des Gehäuses der Spulenanordnung vorgesehen ist. Insbesondere kann es sich bei der Außenseite um eine geschlossene Stirnseite eines Gehäuses handeln, die von der anderen Spulenanordnung fortweist.

Bei der erfindungsgemäßen Ausführungsform umfasst die Platine zusätzliche eine Sende- und/oder Empfangseinrichtung einer opto-elektronischen Signalübertragungseinrichtung. Zwar ist es möglich, sowohl elektrische Leistung, als auch Signale durch eine geeignete Modulation über ein und dasselbe wand- und flügelseitige Spulenpaar zu übertragen. Da jedoch einerseits eine gegenseitige Beeinflussung von Leistungs- und Signalübertragung nicht ausgeschlossen werden kann und andererseits eine optimierte Leistungsübertragung regelmäßig eine andere konstruktive Anpassung der Spulenanordnung als eine optimierte Signalübertragung erfordern, ist bei dieser bevorzugten Weiterbildung auch diese optoelektronische Signalübertragung vorgesehen. Diese kann, wie besonders bevorzugt, Teil einer Regelschleife zur Regelung der Leistung, mit der die wandseitige Spule beaufschlagt wird, in Abhängigkeit von einem flügelseitigen Leistungsbedarf sein. Sie kann aber auch - alternativ oder zusätzlich - beispielsweise die jeweiligen Betriebszustände von im Flügel befindlichen Einrichtungen zwischen dem Flügel und der Wand sowie Steuersignale an diese Einrichtungen von der Wand zum Flügel übertragen.

Die Erfindung soll nun anhand der Zeichnungen, in denen ein Ausführungsbeispiel einer erfindungsgemäßen Vorrichtung dargestellt ist, weiter erläutert werden. Es zeigen:
- Fig. 1: das Ausführungsbeispiel der erfindungsgemäßen Vorrichtung im teilweisen Längsschnitt;
- Fig. 2: den Ausschnitt A in Fig. 1 in einer vergrößerten Darstellung;
- Fig. 3: eine perspektivische Explosionsdarstellung einer eine Leistungsübertragungseinrichtung und einen ersten Optokoppler umfassenden Leistungsübertragungsbaugruppe;
- Fig. 4: eine perspektivische Explosionsdarstellung einer einen zweiten Optokoppler umfassenden Signalübertragungsbaugruppe;
- Fig. 5: ein Blockschaltbild einer wandseitigen elektrischen Schaltung;

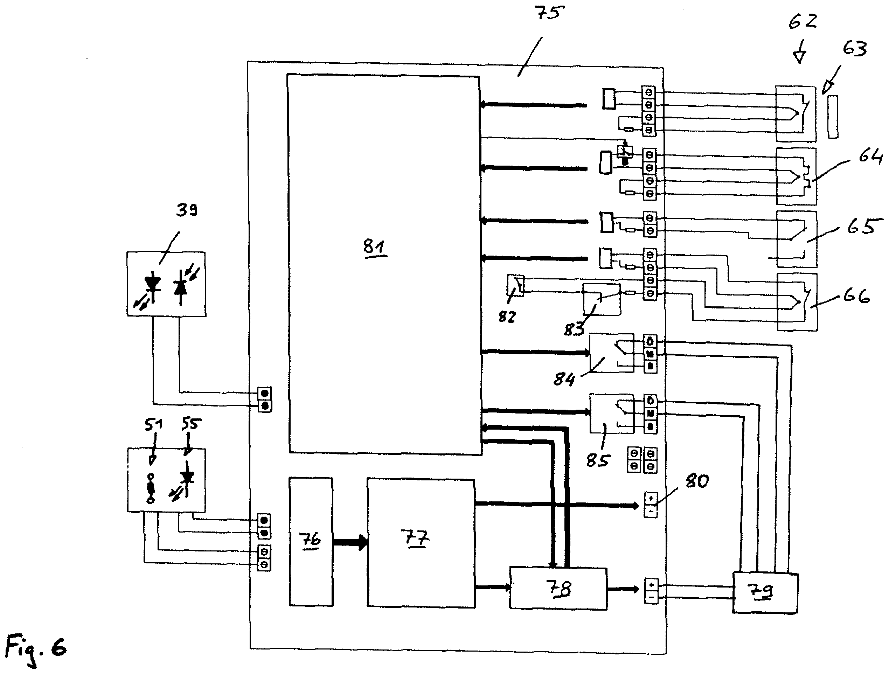

- Fig. 6: ein Blockschaltbild einer flügelseitigen elektrischen Schaltung sowie
- Fig. 7: ein Prinzipschaltbild einer elektronischen Schaltung zur Erzeugung eines Störungssignals beim Erfassen eines Magnetfeldes oberhalb eines Schwellenwertes in einer Umgebung der Übertragungseinrichtung.

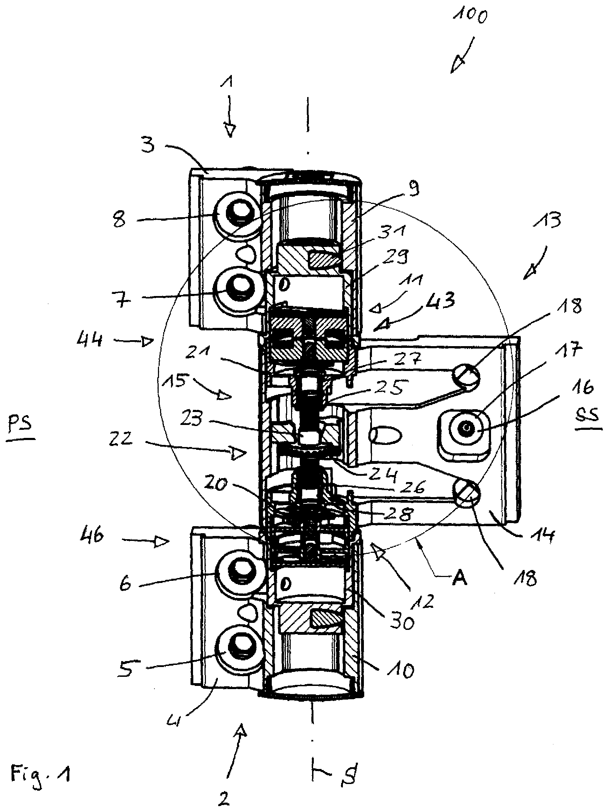

Die in Fig. 1 als Ganzes mit 100 bezeichnete Vorrichtung umfasst zwei Wandteile 1, 2, die in Richtung einer Scharnierachse S voneinander beabstandet an einer in der Zeichnung nicht dargestellten Wand, die eine Tür- oder Fensteröffnung aufweist, befestigbar sind. Die vorstehende oder nachfolgende Verwendung des Begriffs "Wand" schließt einen Rahmen oder eine Zarge ein, die im Bereich einer Tür- oder Fensteröffnung an der Wand üblicherweise vorgesehen ist.

Die Wandteile 1, 2 umfassen Befestigungsteile 3, 4. Jedes Befestigungsteil weist Bohrungen 5, 6, 7, 8 zur Aufnahme jeweils einer Befestigungsschraube oder zum Durchführen von elektrischen und/oder optischen Kabeln auf. Diese Kabel, die in Fig. 1 nicht dargestellt sind, dienen der Herstellung von elektrischen oder optischen Verbindungen von Leistungs- oder Signalübertragern und zugehörigen elektronischen oder optoelektronischen Schaltungen, wie weiter unten noch genauer beschrieben wird.

Üblicherweise bildet die Wand eine Primärseite PS, von der aus elektrische Leistung in den Flügel, der dann die Sekundärseite SS ist, übertragen wird.

An die Befestigungsteile 3, 4 ist jeweils ein Aufnahmeteil 9, 10 zur Aufnahme von Bauteilen von Leistungs- und Signalübertragungsbaugruppen 11, 12 angeformt. Die Leistungs- und Signalübertragungsbaugruppen 11, 12 bilden bei dem hier beschriebenen Ausführungsbeispiel Leistungs- und Signalübertragungseinrichtungen 44, 46. Die Leistungsübertragungsbaugruppe umfasst bei dem beschriebenen Ausführungsbeispiel eine Übertragungseinrichtung 19, die eine wandseitige und eine flügelseitige Spulenanordnung 32, 45 aufweist.

Die Vorrichtung 100 umfasst darüber hinaus ein Flügelteil 13, welches in den zwischen den Wandteilen 1, 2 gebildeten Abstandsraum eingreift. Es weist ebenfalls ein Befestigungsteil 14 und ein an das Befestigungsteil 14 angeformtes Aufnahmeteil 15 auf. An dem Befestigungsteil 14 ist eine Bohrung 16 für eine Befestigungsschraube 17 vorgesehen, mit welcher das Flügelteil 13 an einem in der Zeichnung nicht dargestellten Flügel montierbar ist. Das Befestigungsteil 14 weist darüber hinaus noch Bohrungen 18 auf, die der Durchleitung von elektrischen und/oder optischen Kabeln 19 dienen, die in der Zeichnung nicht dargestellt sind. Diese Kabel dienen der Verbindung der Leistungs- und Signalübertragungsbaugruppen 11, 12 mit flügelseitigen elektronischen oder optoelektronischen Schaltungen, hier einer Primärelektronik 60 und einer Sekundärelektronik 75.

Das Aufnahmeteil 15 dient der Aufnahme von flügelseitigen Bauteilen zu Leistungs- und Signalübertragungsbaugruppen 11, 12. Die flügelseitigen Bauteile umfassen zwei Lagerhülsen 20, 21 die in Richtung der Scharnierachse S voneinander beabstandet und in diese Richtung relativ zueinander verschiebbar gelagert sind. Der Verschiebung und Fixierung in einer gewünschten Position dient ein Spindelantrieb 22. Er umfasst eine Stellspindel 23, die mittig ein Kronenrad 24 umfasst. Dieses Kronenrad 24 dient dem wahlweise Ansetzen eines in der Zeichnung nicht dargestellten Drehwerkzeugs oder dem Eingriff einer in der Zeichnung ebenfalls nicht erkennbaren Drehbetätigungseinrichtung. Die Stellspindel 24 weist darüber hinaus zwei Gewindebereiche 25, 26 auf, die im umgekehrten Sinne ausgebildete Außengewinde umfassen. Die Gewindebereiche 25, 26 greifen in komplementäre Innengewinde 27, 28 der Lagerhülsen 20, 21 ein. Durch Drehbetätigung des Spindelantriebs 22 lassen sich somit die Lagerhülsen 20, 21 in Richtung der Scharnierachse S verlagern, um so zwischen einer Montageposition, in der die Lagerhülsen 20, 21 einen minimalen Abstand voneinander aufweisen, und einer Betriebsposition, in welcher die Lagerhülsen 20, 21 an Lagerhülsen 29, 30 in den Aufnahmeteilen 9, 10 der Wandteile zumindest nahezu anliegen, verstellt zu werden.

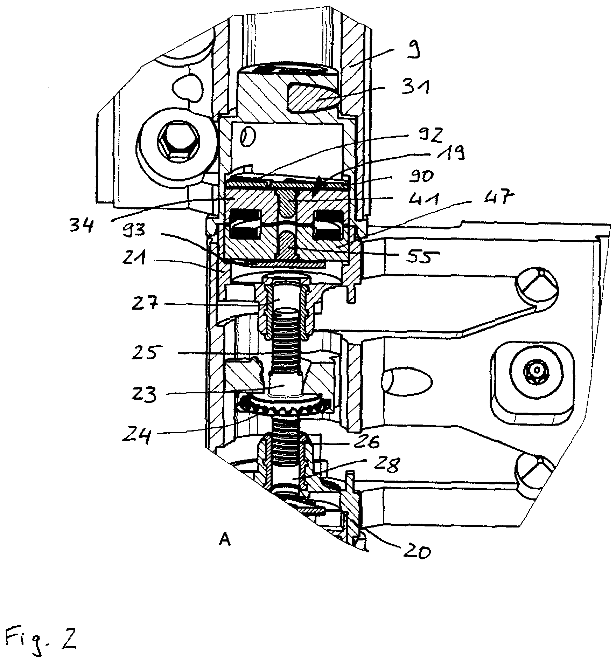

Der Aufbau und die Wirkungsweise der Leistungs- und Signalübertragungsbaugruppen sollen nachfolgend unter Bezugnahme auf die Fig. 2 bis 4 näher erläutert werden.

Die Leistungsübertragungsbaugruppe 11 umfasst neben der Lagerhülse 21, welche verschiebbar in dem Aufnahmeteil 15 des Flügelteils 13 mit Hilfe der Stellspindel 23 verschiebbar gelagert ist, die Lagerhülse 29, die in dem Aufnahmeteil 9 angeordnet ist. Die funktionell entsprechende Lagerhülse 30 ist dementsprechend in dem Aufnahmeteil 10 des unteren Bandteils 2 angeordnet (s. Fig. 1). Eine Verlagerbarkeit der Lagerhülsen 29, 30 in Richtung der Scharnierachse S ist nicht vorgesehen. Die obere Lagerhülse 29 umfasst eine radial vorstehende Klemmeinrichtung 31, damit sie drehfest gelagert ist und nach einem eventuellen Entfernen des Flügelteils 13 nicht selbsttätig nach unten herausfällt.

In der Lagerhülse 29 ist eine wandseitige Spulenanordnung 32, auch "Primärspulenanordnung" genannt, angeordnet. Sie umfasst ein Spulengehäuse 34, das aus einem weichmagnetischen, insbesondere ferritischen Material bestehen kann. Es weist einen zentralen Kern 36 auf, um welchen eine Spulenwicklung 38 geführt ist. Diese Spulenwicklung 38 ist in der Zeichnung lediglich schematisch dargestellt. In dem Kern 36 ist eine zentrale Bohrung 40 vorgesehen. Sie dient der Aufnahme einer optoelektronischen Sende/Empfangseinheit 41, welche Teil einer ersten optoelektronischen Signalübertragungseinrichtung 43 ist. Die optoelektronische Sende/Empfangseinheit 41 ist an einer Platine 90 gelagert.

Die Platine 90 enthält eine elektronische Schaltung zum Betrieb der optoelektronischen Sende/Empfangseinheit 41. Hierzu ist sie über eine zweiadrige Leitung 91 mit einem Schaltwandler 73 der Primärelektronik 60 verbunden, welcher auch die zum Betrieb der optoelektronischen Sende/Empfangseinheit 41 nötige Betriebsspannung und den nötigen Betriebsstrom zur Verfügung stellt.

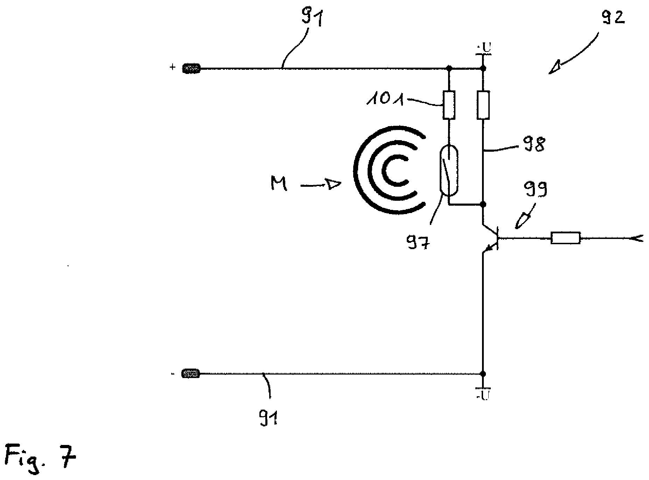

Ferner umfasst die Platine 90 eine Einrichtung zur Erfassung der Magnetfeldstärke 92 von der in Fig. 7 ein Prinzipschaltbild dargestellt ist, die bei dem dargestellten Ausführungsbeispiel einen als Reedschalter ausgebildeten Magnetfeldsensor 97 aufweist. Die elektrische Schaltung der Platine ist derart ausgebildet, dass sich bei Erfassung eines Magnetfelds, dessen Magnetfeldstärke oberhalb eines Schwellenwerts liegt, mit Hilfe des Reedschalters oder des Hallsensors sich der Leistungsbedarf der elektrischen Schaltung signifikant erhöht und diese Erhöhung des Leistungsbedarfs zur Erzeugung eines die Erfassung eines äußeren Magnetfelds symbolisierenden Störungssignals verwendet wird. Hierzu ist parallel zu einer Basisleitung 98 eines Transistors 99, der Teil eines Rückkanals zur bedarfsgerechten Regelung der mittels der Primärspulenanordnung 32 bereitgestellten elektrischen Leistung dient, einer aus Magnetfeldsensor 97 und Widerstand 101 bestehende Reihenschaltung geschaltet. Wird aufgrund eines äußeren Magnetfeldes M der Magnetfeldsensor 97 auf Durchlass geschaltet, so führt dies zu der signifikanten Erhöhung des Leistungsbedarfs.

Damit die Einrichtung zur Erfassung der Magnetfeldstärke 92 nicht von Magnetfeldern beeinflusst wird, die aufgrund eines Stromflusses durch die Spulenwicklung 38 erzeugt werden, ist die Platine 90 an der Außenseite des Spulengehäuses 34 angeordnet.

Im Aufnahmeteil 15 des Flügelteils 13 ist eine flügelseitige Spulenanordnung 45, auch Sekundärspulenanordnung genannt, angeordnet. Sie umfasst ein Spulengehäuse 47 mit einem Kern 49, um welchen herum eine Spulenwicklung 51 gewunden ist.

Das Spulengehäuse 47 weist wiederum eine zentrale, sich durch den Kern 49 erstreckende zentrale Bohrung 53 auf. Sie dient der Aufnahme einer optoelektronischen Sende/Empfangseinheit 55. Die optoelektronischen Sendeeinheiten 41, 55 sind derart aufeinander abgestimmt, dass eine Signalübertragung zumindest in einer Richtung, vorzugsweise bidirektional möglich ist. Beide optoelektronischen Sende/Empfangseinheiten 41, 55 bilden zusammen einen ersten Optokoppler 48. Die optoelektronische Sende/Empfangseinheit 55 ist an einer Platine 93 angeordnet. Letztere umfasst eine elektrische Schaltung, die zum Betrieb der optoelektronischen Sende/Empfangseinheit 55 und der Signalübertragung mittels einer zweiadrigen Leitung 94 geeignet ist. Eine Einrichtung zur Erfassung der Magnetfeldstärke eines äußeren magnetischen Feldes ist bei dem dargestellten Ausführungsbeispiel auf der Platine 93 nicht vorgesehen.

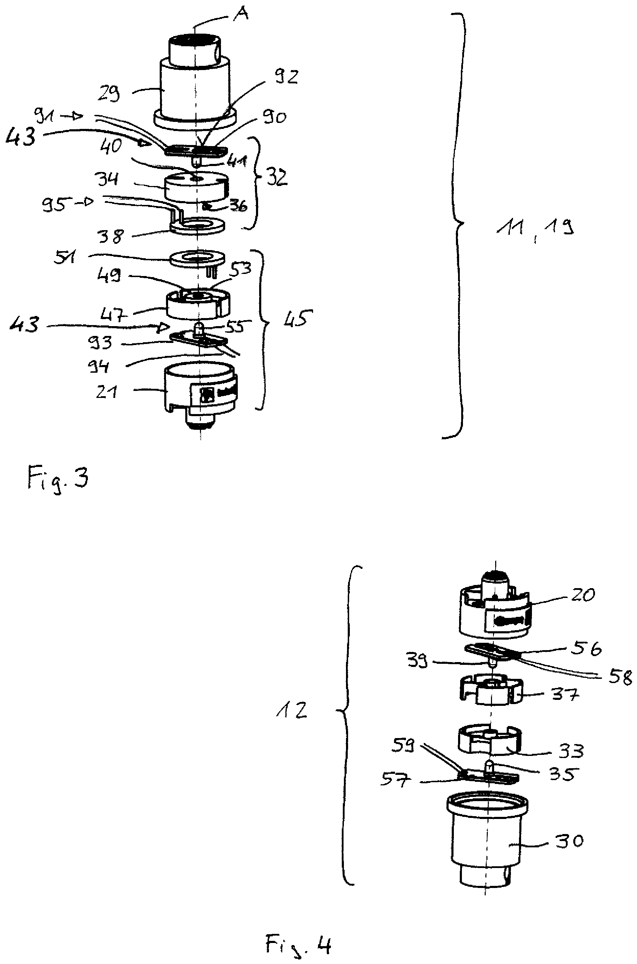

Wie in Fig. 3, in welcher die Leistungsübertragungsbaugruppe 11 in einer perspektivischen Explosionsdarstellung gezeigt ist, erkennbar ist, sind die Bauteile dieser Baugruppe etwa symmetrisch zu einer zentralen Achse A angeordnet. Im montierten Zustand fällt diese Achse A etwa mit der Scharnierachse S zusammen.

In Fig. 4 ist in einer etwa Fig. 3 entsprechenden Darstellung die Signalübertragungsbaugruppe 12 dargestellt. Sie umfasst die Lagerhülse 30, einen ersten Träger 33, eine erste optoelektronische Sende/Empfangseinheit 35, einen zweiten Träger 37, eine zweite optoelektronische Sende/Empfangseinheit 39 und die Lagerhülse 20. Die optoelektronischen Sende/Empfangseinheiten 35, 39 sind jeweils auf einer Platine 56, 57 angeordnet. Beide Platinen 56, 57 umfassen elektrische Schaltungen zum Betrieb der jeweiligen optoelektronischen Sende/Empfangseinheit über jeweils eine zweiadrige Leitung 58, 59. Die Platinen 56, 57 sind an voneinander fortweisenden Stirnseiten der Einsätze 30, 37 befestigt.

Die Signalübertragungsbaugruppe 12 umfasst keine Spulenanordnungen. Die Träger 30, 37 können aus einem Kunststoffmaterial hergestellt sein. Da es somit an einer Leistungs- und/oder Signalübertragung auf induktivem Wege fehlt, ist auch auf keiner der beiden Platinen 56, 57 eine Einrichtung zur Erfassung einer äußeren Magnetfeldstärke vorgesehen.

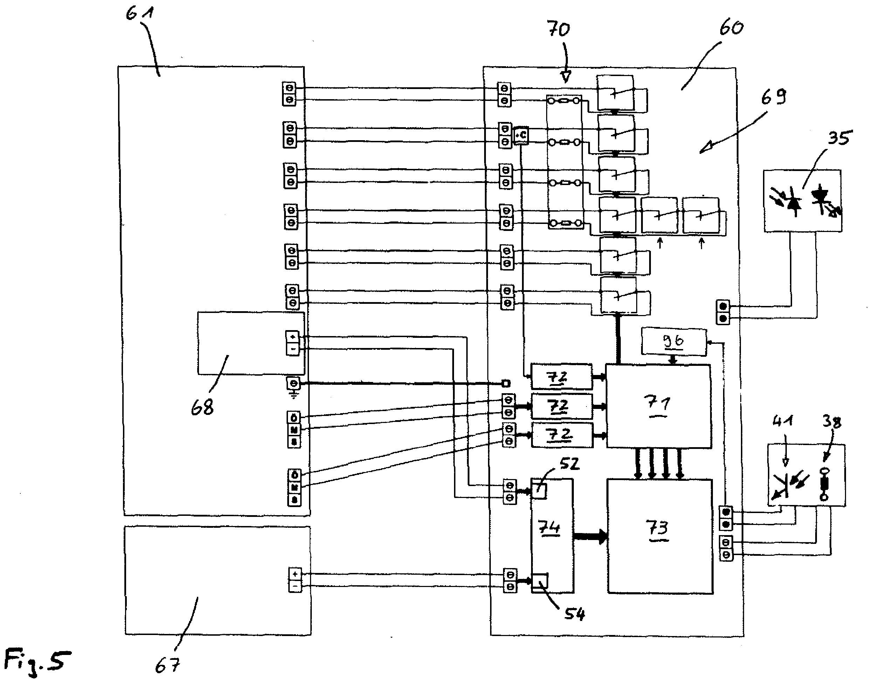

Die in Fig. 5 als Blockschaltbild dargestellte, rahmenseitige elektrische Schaltung umfasst eine Primärelektronik 60, die unter anderem der Bereitstellung der elektrischen Leistung in Abhängigkeit des flügelseitigen Betätigungs- und Betriebsleistungsbedarfs dient. Hierzu ist die Primärelektronik 60 über die Leitung 91 sowohl mit der optoelektronischen Sende/Empfangseinheit 41, als auch über eine zweiadrige Leitung 95 mit der Spulenwicklung 38 der Primärspulenanordnung 32 elektrisch verbunden.

Um Signale zwischen einer wandseitigen Ansteuer- und Auswerteinrichtung - bei dem dargestellten Ausführungsbeispiel gebildet durch eine Einbruchmeldezentrale 61, flügelseitigen Signalgebern 62 in Form von Magnetkontakten 63, Glasbruchsensoren 64, Schließkontakten 65 sowie Sabotagekontakten 66 - bidirektional übertragen zu können, ist die Primärelektronik darüber hinaus elektrisch auch mit der optoelektronischen Sende/Empfangseinheit 35 verbunden.

Ferner ist die Primärelektronik 60 elektrisch an ein Leistungsnetzteil 67, welches im Bedarfsfall die flügelseitige Betätigungsleistung zur Verfügung stellt, sowie an eine gepufferte Stromversorgung 68, die Teil der Einbruchmeldezentrale 61 ist und für den Falle eines Versorgungsspannungsausfalls oder eines technischen Defekts des Leistungsnetzteils 67 der flügelseitigen Bereitstellung des Betriebsleistungsbedarfs der Signalgeber 62 dient, angeschlossen. Ist kein flügelseitiger Verbraucher vorhanden, kann das Leistungsnetzteil 67 entfallen.

Die Primärelektronik 60 umfasst darüber hinaus eine Vielzahl von Relais 69, die von einer Öffnungs-, Durchbruchs-, Verschluss- und zur Montageüberwachung übermittelte Signale abbilden. Sie sind mit den entsprechenden Eingängen der Einbruchmeldezentrale verbunden, wobei Anschlusswiderstände 70 mit den Verbindungsleitungen in Reihe geschaltet sind. Ferner sind Relais für einen Abhebekontakt und das ein äußeres Magnetfeld anzeigende Signal sowie zur Übermittlung von durch einen "Watchdog" übermittelte Störungen vorgesehen.

Die Relais 69 werden in Abhängigkeit der durch die erste optoelektronische Sende/Empfangseinheit 35 übermittelten Signale von einem Prozessor 71 der Primärelektronik 60 angesteuert. Der Prozessor 71 erhält über Auswerteelektroniken 72 Informationen über die Meldegruppenspannung sowie Signale der Einbruchmeldezentrale 61, beispielsweise für eine Riegel- und Fallen-Steuerung.

Der Prozessor 71 ist darüber hinaus mit einem Schaltwandler 73 verbunden, welcher die Spulenwicklung 38 in Abhängigkeit des von dem Prozessor ermittelten Leistungsbedarfs über die optoelektronische Sende/Empfangseinheit 41 rückgekoppelt mit elektrischer Leistung beaufschlagt.

Diese elektrische Leistung wird dem Schaltwandler über eine Umschaltung 74 im normalen Betriebszustand von dem Leistungsnetzteil 67 oder im Falle eines Versorgungsspannungsausfalls von der gepufferten Stromversorgung 68 zur Verfügung gestellt. Die Umschaltung 74 umfasst einen ersten elektrischen Energiepuffer 54. Dieser Energiepuffer dient der Bereitstellung der flügelseitigen Betätigungsleistungen für den Fall, dass die Versorgungsspannung während eines Betätigungsvorganges eines Verbrauchers 79 ausfällt. Hierdurch wird vermieden, dass der Betätigungsvorgang abbricht, sollte die Versorgungsspannung hierbei ausfallen. Grundsätzlich erfolgt - sofern ein Verbraucher 79 vorhanden ist - die Bereitstellung sowohl der flügelseitigen Betätigungsleistung, als auch der flügelseitigen Betriebsleistung mittels eines Leistungsnetzteils 67. Nur für den Fall des Ausfalls der mittels des Leistungsnetzteils bereitgestellten Versorgungsleistung werden mittels der Umschaltung 74 auf die gepufferte Stromversorgung umgeschaltet. Der unterbrechungsfreie Betrieb der sicherheitsrelevanten sekundärseitigen Schaltungsteile ist somit sichergestellt. Die vorbeschriebene Art der elektrischen Energieversorgung der Primärelektronik über die Umschaltung 74 kann unabhängig von der weiteren Ausbildung der Vorrichtung 100 zur Erhöhung der Betriebssicherheit einer galvanisch getrennten Beaufschlagung von elektrischer Leistung eines an einem Flügel vorgesehenen elektrischen Verbraucher Verwendung finden.

Um die von der Umschaltung 74 im Schaltwandler bereitgestellte elektrische Gleichspannung in eine zur Beaufschlagung der wandseitigen Spulenwickelung 38 und damit zur Übertragung durch Induktion einer Sekundärwechselspannung in der flügelseitigen Spulenwicklung 51 der Spulenanordnung 45 geeignete Wechselspannung umzuwandeln, umfasst der Schaltwandler 73 eine besondere Variante eines Sperrwandlers. Dieser umfasst eine vier Hochleistungs-MOSFETs aufweisende H-Brücke. Die Ansteuerung der MOSFETs erfolgt über MOSFET Treiber, die von einer intelligenten Logik angesteuert werden. Verwendung hierzu findet ein Controller, der für diesen Anwendungsfall dahingehend optimiert ist, dass sowohl die intelligente schnelle Steuerung der H-Brücke, als auch der Programmablauf zur Überwachung und Steuerung sämtlicher Funktionalitäten der Sekundärelektronik 75 unabhängig voneinander auf engstem Raum realisiert werden. Auf diese Weise kann der Controller in seinem Programmablauf Einfluss auf die Steuerung der H-Brücke nehmen, eine rückwirkende Beeinflussung von der Ansteuerung der H-Brücke auf den Programmablauf des Controllers ist aber ausgeschlossen.

Die flügelseitige Spulenwicklung 51 ist elektrisch an eine flügelseitige Sekundärelektronik 75 angeschlossen. Mit dieser Wechselspannung wird ein Gleichrichter 76 beaufschlagt, der diese Wechselspannung gleichrichtet. Mittels eines Puffers geglättet wird diese Gleichspannung einer Stromversorgung 77 der Sekundärelektronik 75 zugeführt. An diese Stromversorgung 77 ist unter anderem eine Überstromerkennungs- und Lasttrennungs-Schaltung 78 angeschlossen. Sie umfasst einen Leistungsausgang, an welchem flügelseitig vorgesehen elektrische Verbraucher 79 angeschlossen sein können.

Ferner umfasst die Stromversorgung 77 einen stabilisierten, kurzschlussfesten Gleichspannungsausgang 80, an dem beispielsweise Körperschallmelder angeschlossen und mit Betriebsspannung versorgt werden können.

Dem Prozessor 81 wird mittels der Stromversorgung 77 die nötige Betriebsleistung zur Verfügung gestellt. Der Prozessor 81 ist darüber hinaus mit einer Signalleitung mit der Überstromerkennungs- und Lasttrennungsschaltung 78 verbunden, um im Bedarfsfall eine Lasttrennung zu bewirken.

An die Sekundärelektronik 75 sind des Weiteren die optoelektronischen Sende/Empfangseinheiten 55 und 39 angeschlossen.

Im Betrieb der Anordnung wird mittels des Schaltwandlers 73 die Spulenwicklung 38 der Primärspulenanordnung 32 mit der elektrischen Leistung beaufschlagt, die erforderlich ist, um in der Sekundärspulenwicklung 51 der Sekundärspulenanordnung 45 die Betätigungs- und Betriebsleistung bedarfsgerecht zur Verfügung zu stellen. Die Regelung erfolgt über einen durch die optoelektronischen Sende/Empfangseinheiten 41, 55 galvanisch getrennten Rückkanal, der direkt in Hardware auf die Ansteuerung der H-Brücke des Schaltwandlers 73 wirkt. Durch diese Art der Regelung wird ein ausschließlich in Hardware realisierter Sperrwandler eingesetzt, der keinen software-gesteuerten Programmablauf mit entsprechenden Verzögerungs-Reaktionszeiten erfordert. Es können sich jedoch Betriebszustände einstellen, in denen die Ein/Ausschaltfrequenz des Sperrwandlers im hörbaren Bereich liegt. In diesem Fall kann mittels des Controllers software-gesteuert die Regelfrequenz verändert werden. Auch kann ohne Softwaresteuerung ein Betriebszustand auftreten, bei dem das System in einen Überlastungszustand überginge. Auch ein solcher Betriebszustand kann durch software-gesteuertes Abschalten des Sperrwandlers verhindert werden.

Dieser Kanal dient darüber hinaus der Erfassung eines eventuellen äußeren Magnetfelds.

Wie bereits weiter oben erläutert, ist auf der die optoelektronische Sende/Empfangseinheit 41 tragenden Platine eine Einrichtung zur Erfassung der Magnetfeldstärke vorgesehen. Diese ist derart ausgebildet, dass beim Erfassen eines derartigen Magnetfelds sich der Leistungsbedarf der Platine 90 signifikant erhöht, so dass diese Erhöhung von einer dem Prozessor 71 vorgeschalteten Auswertung 96 als Störungssignal interpretiert und das zugeordnete Relais entsprechend angesteuert werden kann.

Ferner findet während des Betriebs über die optoelektronische Sende/Empfangseinheiten 35, 39 eine bidirektionale Signalübertragung statt. Mit dieser können einerseits die Betriebszustände der Signalgeber 62 der Einbruchmeldezentrale 61 bereitgestellt, andererseits der Prozessor 81 und die Signalgeber sowie gegebenenfalls weitere Verbraucher von der Einbruchmeldezentrale 61 angesteuert werden.

Die Sekundärelektronik umfasst des Weiteren einen Sicherheitskontakt 82 für eine Deckelüberwachung und einen Sicherheitskontakt 83 für einen Abhebeschutz. Ferner sind Relais 84, 85 zur Riegel- und Fallensteuerung des als Motorschloss ausgebildeten Verbrauchers 79 vorgesehen.

Als Relais kommen beliebige, fernbetätigbare Schalter in Betracht. Bei dem beschriebenen Ausführungsbeispiel handelt es sich um elektrooptisch arbeitende Schalter.

### Bezugszeichenliste:

- 100: Vorrichtung
- 1: Wandteil
- 2: Wandteil
- 3: Befestigungsteil
- 4: Befestigungsteil
- 5: Bohrung
- 6: Bohrung
- 7: Bohrung
- 8: Bohrung
- 9: Aufnahmeteil
- 10: Aufnahmeteil
- 11: Leistungsübertragungsbaugruppe
- 12: Signalübertragungsbaugruppe
- 13: Flügelteil
- 14: Befestigungsteil
- 15: Aufnahmeteil
- 16: Bohrung
- 17: Befestigungsschraube
- 18: Bohrung
- 19: Übertragungseinrichtung
- 20: Lagerhülse
- 21: Lagerhülse
- 22: Spindelantrieb
- 23: Spindelantrieb
- 24: Kronenrad
- 25: Gewindebereich
- 26: Gewindebereich
- 27: Gewindebereich
- 28: Gewindebereich
- 29: Lagerhülse
- 30: Lagerhülse
- 31: Klemmeinrichtung
- 32: wandseitige Spulenanordnung
- 33: Träger
- 34: Träger
- 35: optoelektronische Sende/Empfangseinheit
- 36: Kern
- 37: Träger
- 38: Spulenwicklung
- 39: optoelektronische Sende/Empfangseinheit
- 40: zentrale Bohrung
- 41: optoelektronische Sende/Empfangseinheit
- 42: Bohrung
- 43: optoelektronische Signalübertragungseinrichtung
- 44: Leistungsübertragungseinrichtung
- 45: flügelseitige Spulenanordnung
- 46: Signalübertragungseinrichtung
- 47: Spulengehäuse
- 48: erster Optokoppler
- 49: Kern
- 50: zweiter Optokoppler
- 51: Spulenwicklung
- 52: Puffer
- 53: Bohrung
- 54: Puffer
- 55: optoelektronische Sende/Empfangseinheit
- 56: Platine
- 57: Platine
- 58: zweiadrige Leitung
- 59: zweiadrige Leitung
- 60: Primärelektronik
- 61: Einbruchmeldezentrale
- 62: Signalgeber
- 63: Magnetkontakte
- 64: Glasbruchsensoren
- 65: Schließkontakte
- 66: Sabotagekontakte
- 67: Leistungsnetzteil
- 68: Stromversorgung
- 69: Relais
- 70: Überwachungswiderstände
- 71: Prozessor
- 72: Auswerteelektroniken
- 73: Schaltwandler
- 74: Umschaltung
- 75: Sekundärelektronik
- 76: Gleichrichter
- 77: Stromversorgung
- 78: Überstromerkennungs- und Lasttrennungsschaltung
- 79: Verbraucher
- 80: Gleichspannungsausgang
- 81: Prozessor
- 82: Sicherheitskontakt
- 83: Sicherheitskontakt
- 84: Relais
- 85: Relais
- 90: Platine
- 91: zweiadrige Leitung
- 92: Einrichtung zur Erfassung der Magnetfeldstärke
- 93: Platine
- 94: zweiadrige Leitung
- 95: zweiadrige Leitung
- 96: Auswertung
- 97: Magnetfeldsensor
- 98: Basisleitung
- 99: Transistor
- 101: Widerstand
- M: Magnetfeld
- PS: Primärseite
- S: Scharnierachse
- SS: Sekundärseite

## Patentansprüche

1. Verfahren zur Übertragung von elektrischer Leistung und/oder von Signalen zwischen einer Wand und einem gegenüber dieser Wand verschwenkbaren Flügel, mit einer Übertragungseinrichtung (19) und einer Einrichtung (92) zur Erfassung einer Magnetfeldstärke,
wobei die Magnetfeldstärke in einer Umgebung der Übertragungseinrichtung (19) erfasst und bei Übersteigen eines Magnetfeldstärken-Schwellenwerts ein Störungssignal erzeugt wird, und
zur Erfassung der Magnetfeldstärke eine elektrische Schaltungsanordnung vorgesehen ist, die mit einer bestimmten Versorgungsspannung betrieben wird, und bei Erfassung eines Magnetfeldes einer oberhalb eines Schwellenwerts liegenden Stärke sich der Leistungsbedarf der Schaltungsanordnung erhöht,
wobei die Schaltungsanordnung derart ausgebildet ist, dass die Erhöhung des Leistungsbedarfs bei Erfassung eines Magnetfeldes zur Erzeugung des Störungssignals verwendet wird.

2. Verfahren nach Anspruch 1, **dadurch gekennzeichnet, dass** das Störungssignal einer Einbruch/Meldezentrale zugeleitet wird.

3. Verfahren nach einem der Ansprüche 1 oder 2, **dadurch gekennzeichnet, dass** die elektrische Leistung und/oder die Signale galvanisch getrennt zumindest auch induktiv übertragen werden.

4. Vorrichtung (100) zur Übertragung von elektrischer Leistung und/oder von Signalen zwischen einer Wand und einem schwenkbar an dieser Wand befestigten Flügel,
mit einer Übertragungseinrichtung (19), die eine wandseitige und eine flügelseitige Spulenanordnung (32, 45) umfasst,
mit einer Einrichtung zur Erfassung der Magnetfeldstärke (92) in einer Umgebung der Übertragungseinrichtung (19), die einen vorzugsweise als Reedschalter und/oder Hallsensor ausgebildeten Magnetfeldsensor (97) sowie eine elektrische Schaltungsanordnung umfasst,
wobei die Schaltungsanordnung mit einer bestimmten Versorgungsspannung betrieben wird, bei Erfassung eines Magnetfeldes einer oberhalb eines Schwellenwerts liegenden Stärke sich der Leistungsbedarf der Schaltungsanordnung erhöht, und die Schaltungsanordnung derart ausgebildet ist, dass die Erhöhung des Leistungsbedarfs bei Erfassung eines Magnetfeldes zur Erzeugung des Störungssignals verwendet wird, wobei der Magnetfeldsensor (97) auf einer Platine (90) der elektrischen Schaltungsanordnung vorgesehen ist, und die Platine (90) an einer Außenseite eines Spulengehäuses (34) der Spulenanordnung (32) vorgesehen ist, und die Platine (90) eine Sende- und/oder Empfangseinrichtung (41) einer optoelektro-nischen Signalübertragungseinrichtung umfasst.

5. Vorrichtung nach Anspruch 4, **dadurch gekennzeichnet, dass** die optoelektronische Signalübertragungseinrichtung (41) Teil einer Regelschleife zur Regelung der Leistung, mit der die wandseitige Spulenwicklung (38) beaufschlagt wird, in Abhängigkeit von einem flügelseitigen Leistungsbedarf ist.

## Claims

1. Method for transmitting electrical power and/or signals between a wall and a leaf which is pivotable with respect to said wall, said method using a transmission means (19) and a means (92) for detecting a magnetic field strength, wherein the magnetic field strength is detected in the surroundings of the transmission means (19) and a fault signal is generated when a magnetic field strength threshold value is exceeded, and an electrical circuit arrangement is provided for detecting the magnetic field strength, which circuit arrangement is operated at a specific supply voltage, and the power demand of the circuit arrangement increases when a magnetic field having a strength which exceeds a threshold value is detected, wherein the circuit arrangement is designed such that the increase in the power demand when a magnetic field is detected is used to generate the fault signal.

2. Method according to claim 1, **characterized in that** the fault signal is sent to an intrusion alarm center.

3. Method according to either claim 1 or claim 2, **characterized in that** the electrical power and/or the signals are transmitted in a galvanically isolated manner and at least inductively.

4. Device (100) for transmitting electrical power and/or signals between a wall and a leaf which is pivotably attached to said wall, said device having a transmission means (19) which comprises a wall-side and a leaf-side coil arrangement (32, 45), having a means for detecting the magnetic field strength (92) in the surroundings of the transmission means (19), which means comprise a magnetic field sensor (97) which is preferably designed as a reed switch and/or as a Hall effect sensor, and an electrical circuit arrangement, wherein the circuit arrangement is operated at a specific supply voltage, the power demand of the circuit arrangement increases when a magnetic field having a strength which exceeds a threshold value is detected, and the circuit arrangement is designed such that the increase in the power demand when a magnetic field is detected is used to generate the fault signal, wherein the magnetic field sensor (97) is provided on a circuit board (90) of the electrical circuit arrangement, and the circuit board (90) is provided on an outer side of a coil housing (34) of the coil arrangement (32), and the circuit board (90) comprises a transmitting and/or receiving means (41) of an optoelectronic signal transmission means.

5. Device according to claim 4, **characterized in that** the optoelectronic signal transmission means (41) is part of a control loop for controlling, in a closed-loop manner, the power which acts upon the wall-side coil winding (38), depending on a leaf-side power demand.

## Revendications

1. Procédé de transmission de puissance électrique et/ou de signaux entre une paroi et une aile pouvant pivoter par rapport à cette paroi, comportant un dispositif de transmission (19) et un dispositif (92) de détection de l'intensité d'un champ magnétique,
dans lequel l'intensité du champ magnétique dans l'environnement du dispositif de transmission (19) est détectée et un signal de perturbation est généré lorsqu'une valeur seuil d'intensité de champ magnétique est dépassée, et un circuit électrique fonctionnant avec une tension d'alimentation déterminée est prévu pour détecter l'intensité du champ magnétique, et les besoins en puissance du circuit électrique augmentent lors de la détection d'un champ magnétique d'une intensité supérieure à une valeur seuil,
dans lequel le circuit électrique est conçu de sorte que l'augmentation de la puissance requise permet de générer le signal de perturbation lors de la détection d'un champ magnétique.

2. Procédé selon la revendication 1, **caractérisé en ce que** le signal de perturbation est transmis à une centrale d'alarme anti-effraction.

3. Procédé selon l'une des revendications 1 ou 2, **caractérisé en ce que** la puissance électrique et/ou les signaux sont transmis de manière isolée galvaniquement et inductive au moins.

4. Dispositif (100) de transmission de puissance électrique et/ou de signaux entre une paroi et une aile montée de façon pivotante sur cette paroi,
comportant un dispositif de transmission (19) comprenant un circuit électrique du côté paroi et un circuit électrique du côté aile (32, 45),
comportant un dispositif de détection de l'intensité du champ magnétique (92) dans un environnement du dispositif de transmission (19) comprenant un capteur de champ magnétique (97) conçu de préférence sous la forme d'un commutateur à anche et/ou un capteur Hall, ainsi qu'un circuit électrique,
le circuit électrique fonctionnant avec une tension d'alimentation déterminée, les besoins en puissance du circuit électrique augmentant lors de la détection d'un champ magnétique d'une intensité supérieure à une valeur seuil, et le circuit électrique étant conçu de sorte que l'augmentation des besoins en puissance permet de générer le signal de perturbation lors de la détection d'un champ magnétique,
le capteur de champ magnétique (97) étant disposé sur une carte de circuit imprimé (90) du circuit électrique, et la carte de circuit imprimé (90) étant disposée sur une face extérieure d'un carter de bobine (34) du circuit électrique (32), et la carte de circuit imprimé (90) comprenant un dispositif émetteur et/ou récepteur (41) d'un dispositif optoélectronique de transmission de signaux.

5. Dispositif selon la revendication 4, **caractérisé en ce que** le dispositif optoélectronique de transmission de signaux (41) fait partie d'une boucle de régulation destinée à réguler la puissance à laquelle la bobine d'enroulement (38) du côté paroi est sollicitée, en réponse à un besoin en puissance du côté aile.
